Europäisches Patentamt

European Patent Office

Office européen des brevets

(11) Veröffentlichungsnummer : **0 146 042**
B1

(12) EUROPÄISCHE PATENTSCHRIFT

(45) Veröffentlichungstag der Patentschrift :
01.02.89

(51) Int. Cl.⁴ : **H 03 K 17/78**, H 01 L 27/14

(21) Anmeldenummer : 84114471.0

(22) Anmeldetag : 29.11.84

(54) Schaltungsanordnung mit einem Fototransistor.

(30) Priorität : 08.12.83 DE 3344428

(43) Veröffentlichungstag der Anmeldung :
26.06.85 Patentblatt 85/26

(45) Bekanntmachung des Hinweises auf die Patenterteilung : 01.02.89 Patentblatt 89/05

(84) Benannte Vertragsstaaten :
CH DE FR GB IT LI

(56) Entgegenhaltungen :
US—A— 4 390 790
IEEE ELECTRON DEVICE LETTERS, Band EDL-1, Nr 5,
Mai 1980, Seiten 81-82 NEW-York, (US). C.-Y. WU et al
: "A new photosensitive voltage-controlled differ
ential negative resistance device".The lambda bip
olar phototransistor

(73) Patentinhaber : Siemens Aktiengesellschaft Berlin
und München
Wittelsbacherplatz 2
D-8000 München 2 (DE)

(72) Erfinder : Tihanyi, Jenö, Dr.-Ing.
Windeckstrasse 1d
D-8000 München 70 (DE)
Erfinder : Fellinger, Christine
Germersheimerstrasse 5
D-8000 München 90 (DE)
Erfinder : Leipold, Ludwig, Dipl.-Ing.
Kurt-Eisner-Strasse 41
D-8000 München 83 (DE)

EP 0 146 042 B1

## Beschreibung

Die vorliegende Erfindung bezieht sich auf eine Schaltungsanordnung mit einem Fototransistor, dessen Basis-Emitterstrecke durch die Drain-Sourcestrecke eines IGFET überbrückt ist. Eine solche Schaltungsanordnung ist z. B. in der Zeitschrift « IEEE Electron Device Letters », Band EDL-1, Nr. 5, Mai 1980, Seite 81 und 82 beschrieben worden. Der Gateanschluß des IGFET ist mit dem Kollektoranschluß des Fototransistors verbunden. Durch diese Schaltung wird der Fototransistor bis zu einer Kollektor-Emitterspannung sehr empfindlich, die kleiner ist als die Einsatzspannung des IGFET. Erreicht die Kollektor-Emitterspannung des Fototransistors die Einsatzspannung des IGFET, so fließt ein Teil des Photostroms unter Umgehung des Emitters-Basis-pn-Übergangs direkt vom Basisanschluß in den Emitteranschluß. Mit steigender Emitter-Kollektorspannung wird der Fototransistor daher immer unempfindlicher.

Bei Phototransistoren ist es üblich, zwischen Basisanschluß und Emitteranschluß einen Widerstand einzuschalten, um die Sperrspannungsfestigkeit des Phototransistors zu erhöhen. Ein solcher Widerstand ist jedoch auch im beleuchteten Zustand des Fototransistors wirksam und verschlechtert seine Stromverstärkung.

Der Erfindung liegt die Aufgabe zugrunde, eine Schaltungsanordnung der beschriebenen Art so zu verbessern, daß der Fototransistor im unbeleuchteten Zustand am unempfindlichsten ist und mit zunehmende Belichtung des Fototransistors immer empfindlicher wird.

Diese Aufgabe wird dadurch erreicht, daß der IGFET vom Verarmungstyp ist, daß der Gateanschluß des IGFET auf festem Potential liegt und daß zwischen dem Emitter des Fototransistors und dem Gateanschluß des IGFET ein Widerstand liegt, so daß die Empfindlichkeit des Phototransistors mit zunehmendem einfallendem Licht zunimmt.

Weiterbildungen der Erfindung sind Gegenstand der Unteransprüche.

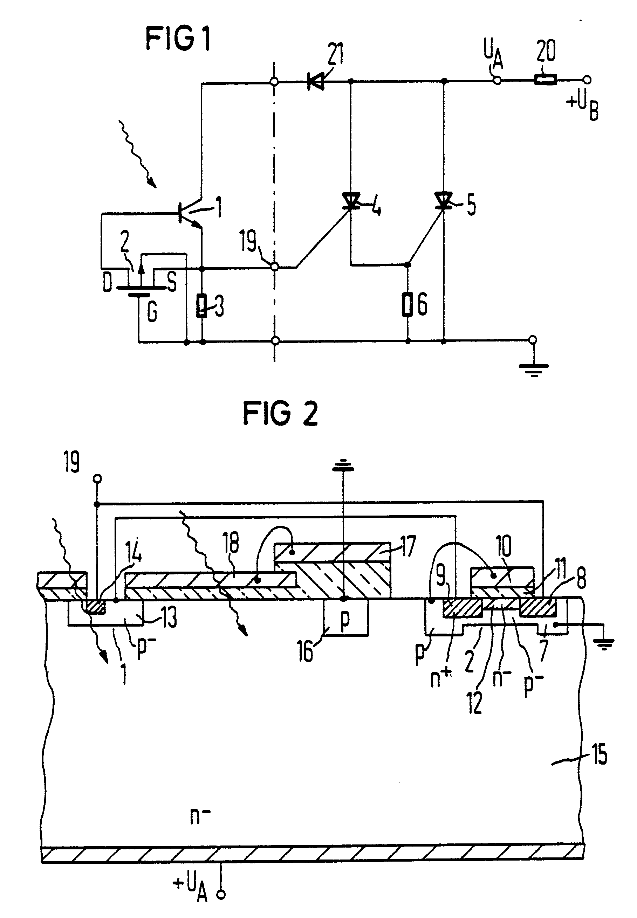

Die Erfindung wird an Hand eines Ausführungsbeispiels in Verbindung mit den Fig. 1 und 2 näher erläutert. Es zeigen :

Fig. 1 die erfindungsgemäße Schaltung zum Ansteuern eines oder mehrerer Thyristoren und

Fig. 2 den Schnitt durch eine integrierte Schaltung, die die auf der linken Seite der gestrichelten Linie liegenden Bestandteile der Anordnung nach Fig. 1 enthält.

Die Schaltungsanordnung nach Fig. 1 enthält einen Fototransistor 1, dessen Kollektor über einen Lastwiderstand 20 mit einer Klemme einer Spannungsquelle mit der Spannung $+U_B$ verbunden ist. Zum Schutz des Fototransistors gegen Spannungsumkehr kann in die Zuleitung eine Diode 21 eingeschaltet sein. Der Emitter des Fototransistors 1 liegt über einen Widerstand 3 oder eine Diode an der anderen Klemme der Spannungsquelle, z. B. an Masse. Der Basisanschluß des Fototransistors ist über die Source-Drainstrecke eines IGFET 2 mit dem Emitteranschluß des Fototransistors verbunden. Hierbei kann entweder die Sourcezone oder die Drainzone mit dem Basisanschluß verbunden sein. Im Ausführungsbeispiel sei es die Drainzone. Der IGFET ist vom Verarmungstyp (Depletion-Type). Der Gateanschluß G des IGFET 2 liegt auf festem Potential, z. B. ebenfalls auf Massepotential.

Im unbeleuchteten Zustand liegt am Fototransistor 1 die volle Spannung $U_B$ an. Hierbei fließt sein Kollektor-Basis-Sperrstrom durch die Source-Drainstrecke des IGFET 2 zum Emitteranschluß des Fototransistors. In diesem Zustand ist das Potential am Emitter des Fototransistors 1 bzw. an der Sourcezone des IGFET 2 gleich bzw. nur geringfügig höher als das Gatepotential bzw. Massepotential. Der IGFET 2 ist damit geöffnet und leitet den Kollektor-Basis-Sperrstrom des Fototransistors 1 ab.

Mit einsetzendem Lichteinfall wird das Emitterpotential des Fototransistors und das Sourcepotential des IGFET höher und der Kanalwiderstand des IGFET 2 wird größer, da das Gatepotential festgehalten wird. Der IGFET 2 ist zweckmäßigerweise so dimensioniert, daß er bei Nennlichtleistung gesperrt ist. Damit fließt praktisch kein Basisstrom mehr und ein maximaler Wert der Stromverstärkung des Fototransistors 1 ist erreicht.

Mit dem Fototransistor 1 läßt sich der Strom durch die Last 20 direkt steuern. Für höhere Ströme ist es zweckmäßig, den Fototransistor zum Ansteuern eines Thyristors oder zum Ansteuern mehrerer in Kaskade gesteuerter Thyristoren zu benutzen. Im rechts von der gestrichelten Linie der Fig. 1 befindlichen Teil ist ein Thyristor 4 dargestellt, der durch den Emitterstrom des Fototransistors 1 gesteuert wird. Dieser Thyristor kann der Hauptthyristor selbst oder ein Hilfsthyristor für einen nachgeschalteten Hauptthyristor 5 sein. Zwischen dem Gateanschluß und den Katodenanschluß des Thyristors 5 liegt ein Widerstand 6, der in bekannter Weise zur Verbesserung der du/dt-Eigenschaften dient. Der Emitterwiderstand 3 für den Fototransistor 1 hat gleichzeitig auch die Wirkung einer du/dt-Verbesserung für den Hilfsthyristor 4. Da ein Thyristor im allgemeinen immer einen Katoden-Basisnebenschluß aufweist, kann der separate Widerstand 3 entfallen, wenn der Fototransistor einen Thyristor steuert. Der Transistorstrom fließt dann durch die Gate-Katodenstrecke des Thyristors. Im unbelichteten Zustand des Fototransistors fließt kein Emitterstrom und die Thyristoren 4, 5 bleiben gesperrt. Im belichteten Zustand des Fototransistors zündet sein Emitterstrom den Hilfsthyristor 4 und dessen Laststrom zündet den Haupthyristor 5.

Der Fototransistor 1 und der Verarmungs-IGFET 2 lassen sich einfach in integrierter Form aufbauen, wie in Fig. 2 dargestellt. Grundlage für die integrierte Schaltung ist ein beispielsweise schwach n-dotierter Halbleiterkörper 15. Dieser kann einen spezifischen Widerstand zwischen 30 und 50 Ohm cm haben. In den Halbleiterkörper 15 ist ein Substrat 7 vom entgegengesetzten Leitungstyp eingebettet. Dieses hat stärker und schwächer dotierte Teile. In dieses Substrat 7 ist eine Sourcezone 8 und eine Drainzone 9 wiederum vom ersten Leitungstyp eingebettet. Zwischen Sourcezone 8 und Drainzone 9 liegt eine Kanalzone 12 vom gleichen Leitungstyp wie Source- und Drainzone, jedoch schwächer dotiert. Das Substrat 7 ist unter der Gatezone 12 ebenfalls schwächer dotiert als im übrigen Bereich, was durch die Dotierung p⁻ angedeutet ist. Über der Gatezone liegt eine Isolierschicht 11, beispielsweise aus Siliciumdioxid. Auf der Isolierschicht 11 liegt eine Gateelektrode 10, die beispielsweise aus dotiertem polykristallinem Silicium besteht.

Für den genannten Zweck hat sich eine Dotierung der Source- und Drainzone von z. B. $10^{20}$ cm$^{-3}$, eine Dotierung des Substrats mit z. B. $10^{16}$ bis $10^{17}$ cm$^{-3}$ für den p⁻-dotierten Teil und eine Dotierung mit $10^{15}$ bis $10^{16}$ cm$^{-3}$ für den p⁻-dotierten Teil als zweckmäßig erwiesen. Die Dicke des Gateoxids beträgt z. B. 70 nm, während die Gatezone 12 durch Ionenimplantierung mit einer Dosis von z. B. $1 \cdot 10^{12}$ cm$^{-2}$ Arsenatomen dotiert ist. Der Widerstand des Verarmungs-IGFET 2 hängt dann noch von der Länge der Gatezone und deren Breite ab. Die Länge kann z. B. zwischen 5 und 100 μm und die Breite zwischen 10 und 20 μm liegen. Die Einsatzspannung des MOSFET wird durch die Dotierung der Gatezone 12, die Dotierung des schwächer dotierten Teils des Substrats und durch die Dicke des Gateoxids bestimmt.

In den gleichen Halbleiterkörper 15 ist die Basiszone 13 des Fototransistors 1 eingebettet. Zweckmäßigerweise besitzt sie gleiche Tiefe wie der schwächer dotierte Teil des Substrats 7 und hat die gleiche Dotierungskonzentration. In die Basiszone 13 ist die Emitterzone 14 eingebettet, die stark n-dotiert ist. Sie ist elektrisch mit der Sourcezone 8 verbunden, während die Basiszone 13 elektrisch mit der Drainzone 9 verbunden ist. Das Substrat 7 ist außerdem elektrisch mit der Gateelektrode 10 verbunden.

Der als Kollektor für den Fototransistor 1 wirkende Teil des Halbleiterkörpers 15 ist mit nach außen ansteigend gestaffelten Feldelektroden 18, 17 überdeckt. Diese haben den Zweck, die Raumladungszone im Kollektor derart zu verformen, daß ein möglichst großer Teil der optisch erzeugten Ladungsträger zur Basiszone 13 fließt. Diese Wirkung kann noch durch eine Hilfszone 16 verstärkt werden, die zwischen der Basiszone 13 und dem Substrat 7 liegt. Diese Hilfszone ist p-dotiert und liegt an einem festen Potential, zweckmäßigerweise an Massepotential. Die Hilfszone 16 hat zweckmäßigerweise gleiche Tiefe und gleiche Dotierung wie die stärker dotierten Teile des Substrats 7. Zur Ableitung von kapazitiven Strömen kann auch das Substrat 7 an Massepotential liegen.

## Patentansprüche

1. Schaltungsanordnung mit einem Phototransistor (1), dessen Basis-Emitterstrecke durch die Drain-Sourcestrecke eines IGFET überbrückt ist, dadurch gekennzeichnet, daß der IGFET (2) vom Verarmungstyp ist, daß der Gateanschluß (G) des IGFET auf festem Potential liegt und daß zwischen dem Emitter des Phototransistors (1) und dem Gateanschluß des IGFET ein Widerstand (3) liegt, so daß die Empfindlichkeit des Phototransistors mit zunehmendem einfallenden Licht zunimmt.

2. Schaltungsanordnung nach Anspruch 1, dadurch gekennzeichnet, daß der IGFET (2) ein Substrat (7) vom ersten Leitungstyp aufweist, das in einen Halbleiterkörper (15) vom zweiten Leitungstyp eingebettet ist, daß die Drain- und die Sourcezone (9 bzw. 8) vom zweiten Leitungstyp und in das Substrat (7) eingebettet sind, daß zwischen Sourcezone (8) und Drainzone (9) eine Gatezone (12) vom ersten Leitungstyp liegt, die niedriger dotiert ist als Source- und Drainzone, daß der Fototransistor (1) eine Basiszone (13) vom ersten Leitungstyp aufweist, die in das Substrat planar eingebettet ist, daß in die Basiszone (13) eine Emitterzone (14) vom zweiten Leitungstyp planar eingebettet ist, daß die Emitterzone (14) elektrisch mit der Sourcezone (8) und die Basiszone (13) elektrisch mit der Drainzone (9) verbunden ist.

3. Schaltungsanordnung nach Anspruch 2, dadurch gekennzeichnet, daß das Substrat (7) und der Gateanschluß auf Massepotential liegen.

4. Schaltungsanordnung nach Anspruch 3, dadurch gekennzeichnet, daß das Substrat (7) einen höher und einen niedriger dotierten Bereich aufweist und daß der niedriger dotierte Bereich unter der Gatezone (12) liegt.

## Claims

1. Circuit arrangement with a phototransistor (1), the base-to-emitter path of which is bridged by the drain-to-source path of an IGFET, characterized in that the IGFET (2) is of the depletion type, in that the gate terminal (G) of the IGFET lies at fixed potential and in that, between the emitter of the phototransistor (1) and the gate terminal of the IGFET, a resistor (3) lies, so that the sensitivity of the phototransistor increases as the incident light increases.

2. Circuit arrangement according to Claim 1, characterized in that the IGFET (2) has a substrate (7) of the first conduction type which is embedded in a semiconductor body (15) of the second conduction type, in that the drain region and the source region (9 and 8 respectively) are of the second conduction type and are embedded in the substrate (7), in that between source region (8) and drain region (9) a gate region (12) of the first conduction type lies which has a lesser doping than the source region and drain region, in that the phototransistor (1) has a base region (13) of the first conduction type which is embedded so as to be planar in the substrate, in that an emitter region (14) of the second conduction type is embedded so as to be planar in the base region (13), in that the emitter region (14) is electrically connected to the source region (8) and the base region (13) is electrically connected to the drain region (9).

3. Circuit arrangement according to Claim 2, characterized in that the substrate (7) and the gate terminal lie at ground potential.

4. Circuit arrangement according to Claim 3, characterized in that the substrate (7) has an area of greater and lesser doping and in that the area of lesser doping lies under the gate region (12).

**Revendications**

1. Montage comportant un phototransistor (1), dont la voie base-émetteur est shuntée par la voie drain-source d'un transistor IGFET, caractérisé par le fait que le transistor IGFET (2) est du type à appauvrissement, que la borne de grille (G) du transistor IGFET est placée à un potentiel fixe et qu'une résistance (3) est branchée entre l'émetteur du phototransistor (1) et la borne de grille du transistor IGFET de sorte que la sensibilité du phototransistor augmente lorsque la lumière incidente augmente.

2. Montage suivant la revendication 1, caractérisé par le fait que le transistor IGFET (2) comporte un substrat (7) possédant le premier type de conductivité, qui est inséré dans un corps semiconducteur (15) possédant le second type de conductivité, que les zones de drain et de source (9, 8) possèdent le second type de conductivité et sont insérées dans le substrat (7), qu'entre la zone de source (8) et la zone de drain (9) se trouve disposée une zone de grille (12) possédant le premier type de conductivité, qui est dopée plus faiblement que les zones de source et de drain, que le phototransistor (1) possède une zone de base (13) possédant le premier type de conductivité qui est inséré selon une disposition planar dans le substrat, qu'une zone émetteur (14) possédant le second type de conductivité est disposée selon une disposition planar dans la zone de base (13), que la zone d'émetteur (14) est raccordée électriquement à la zone de source (8) et que la zone de base (13) est raccordée électriquement à la zone de drain (9).

3. Montage suivant la revendication 2, caractérisé par le fait que le substrat (7) et la borne des grilles sont placés au potentiel de masse.

4. Montage suivant la revendication 3, caractérisé par le fait que le substrat (7) possède une zone plus fortement dopée et une zone plus faiblement dopée et que la zone plus faiblement dopée est située au-dessous de la zone de grille (12).

# FIG 1

# FIG 2